# EUROPEAN PATENT SPECIFICATION

(11) **EP 2 605 069 B1**
(45) Date of publication and mention of the grant of the patent: **22.09.2021**
(21) Application number: 11816411.0
(22) Date of filing: 09.08.2011
(51) Int. Cl.: G03F 7/32, G03F 7/40

(54) **RINSE LIQUID FOR LITHOGRAPHY AND METHOD FOR FORMING PATTERN USING SAME**
SPÜLFLÜSSIGKEIT FÜR DIE LITHOGRAFIE UND VERFAHREN ZUR HERSTELLUNG EINER STRUKTUR DAMIT
LIQUIDE DE RINÇAGE POUR LA LITHOGRAPHIE ET PROCÉDÉ POUR FORMER UN MODÈLE UTILISANT CELUI-CI

(30) Priority: 13.08.2010 JP 2010181305
(43) Date of publication of application: 19.06.2013
(73) Proprietor: Merck Patent GmbH, 64293 Darmstadt (DE)
(72) Inventor: WANG Xiaowei, Kakegawa-shi Shizuoka 4371412 (JP); MATSUURA Yuriko, Kakegawa-shi Shizuoka 4371412 (JP); PAWLOWSKI Georg, Kakegawa-shi Shizuoka 4371412 (JP)
(74) Representative: Rippel, Hans Christoph
(86) International application number: PCT/JP2011/068109
(87) International publication number: WO 2012/020747

(56) References cited:
- EP-A1- 1 752 828
- EP-A1- 1 804 124
- EP-A1- 1 832 931
- WO-A1-2006/025303
- JP-A- 11 295 902
- JP-A- 11 352 701
- JP-A- 2004 078 217
- JP-A- 2005 221 615
- JP-A- 2006 011 054
- JP-A- 2006 163 212
- JP-A- 2008 102 343
- US-A1- 2005 250 054

## Description

### TECHNICAL FIELD

The present invention relates to a rinse solution for lithography. Specifically, this invention relates to a rinse solution suitable for development of a photosensitive resin composition used in a lithographic process for manufacturing semiconductor devices, color filters, flat panel displays (FPDs) such as liquid crystal displays, and the like. The present invention also relates to a pattern formation method employing the above rinse solution.

### BACKGROUND ART

Hitherto, photolithography has been adopted for microfabrication or for formation of fine elements in extensive fields including the manufacture of semiconductor integrated circuits such as LSIs, the preparation of FPD screens, and the production of circuit boards for color filters, thermal heads and the like. In the photolithography, a positive- or negative-working photosensitive resin composition is employed for resist pattern formation. Widely used examples of the positive-working photoresist include a photosensitive resin composition comprising an alkali-soluble resin and a photosensitive substance of quinonediazide compound.

Meanwhile, according as the integration degree of LSIs has needed to be increased more and more recently, it has been required to increase fineness of resist patterns. In order to meet this requirement, it is becoming practical for a lithographic process to use radiation of shorter wavelength such as deep UV light emitted from a KrF excimer laser (248 nm), an ArF excimer laser (193 nm), an Extreme Ultra-violet (EUV ; 13 nm), X-ray or an electron beam or the like. For coping with finer fabrication, the photoresist used in microfabrication must be a photosensitive resin composition capable of giving a pattern of high resolution. Further, it is also desired that the photosensitive resin composition be improved not only in resolution but also in sensitivity and in accuracy on shape and dimension of the pattern. In view of that, a "chemically amplified photosensitive resin composition" is proposed as a radiation-sensitive resin composition having sensitivity to the radiation of short wavelength and giving a pattern of high resolution. The chemically amplified photosensitive resin composition comprises a compound that generates an acid when exposed to radiation, and hence when the radiation is applied, the compound generates an acid and the acid serves as a catalyst in image-formation to improve sensitivity. Because of its high sensitivity, the chemically amplified photosensitive resin composition is becoming widely used in place of conventional photosensitive resin compositions.

However, in accordance with increasing the fineness in pattern fabrication as described above, problems such as pattern collapse and pattern roughness are liable to get worse. To cope with those problems, various methods have been researched. For example, it is studied to change or improve components of the resist compositions.

When a resist pattern is washed with pure water after development, the surface tension of pure water may apply negative pressure on the pattern. This is thought to be a cause of the pattern collapse. Based on this thought, it is proposed to wash the pattern not with pure water but with a rinse solution containing a particular component (see, Patent documents 1 to 4). Those patent documents propose rinse solutions for lithography, and the proposed solutions contain particular nonionic surfactants.
[Patent document 1] Japanese Patent Laid-Open No. 2004-184648
[Patent document 2] Japanese Patent Laid-Open No. 05(1993)-299336
[Patent document 3] Japanese Patent Laid-Open No. 07(1995)-140674
[Patent document 4] Japanese Patent Laid-Open No. 2008-146099

EP 1 804 124 A1, US 2005/250,054 A1, EP 1 832 931 A1, EP 1 752 828 A1, JP 2006 163212 A, JP 2006 011054 A, WO 2006/025303 A1, JP 2008 102343 A and JP 11 352701 A disclose rinse solutions comprising a nitrogen containing compound.

JP 11 295902 A discloses tetramethyl hexamethylenediamine as a component of a rinse solution.

JP 2004 078217 A discloses a rinse solution comprising a dialkylated diamine as well as a nonionic surfactant.

### DISCLOSURE OF INVENTION

### PROBLEM TO BE SOLVED BY THE INVENTION

However, although the solutions described in the above documents somewhat reduce the pattern collapse, they are still desired to be improved. Further, taking into consideration that miniaturization often induces melting of patterns, there is much room for improvement in the above solutions. Accordingly, it is desired to provide such a rinse solution for lithography or a resist substrate treatment method as can solve both the pattern collapse and the melting at the same time.

### MEANS FOR SOLVING PROBLEM

The present invention resides in a rinse solution for lithography, which comprises water and at least one nitrogen-containing compound selected from the group consisting of the compounds
N,N,N',N'-tetramethylethylenediamine,
N,N,N',N'-tetraethylethylenediamine,
N,N,N',N'-tetrapropylethylenediamine,
N,N,N',N'-tetraisopropylethylenediamine,
N,N,N',N'-tetrabutylethylenediamine,
N,N,N',N'-tetraisobutylethylenediamine,
N,N,N',N'-tetramethyl-1,2-propylenediamine,
N,N,N',N'-tetraethyl-1,2-propylenediamine,
N,N,N',N'-tetrapropyl-1,2-propylenediamine,
N,N,N',N'-tetraisopropyl-1,2-propylenediamine,
N,N,N',N'-tetrabutyl-1,2-propylenediamine,
N,N,N',N'-tetraisobutyl-1,2-propylenediamine,
N,N,N',N'-tetramethyl-1,3-propylenediamine,
N,N,N',N'-tetraethyl-1,3-propylenediamine,
N,N,N',N'-tetrapropyl-1,3-propylenediamine,
N,N,N',N'-tetraisopropyl-1,3-propylenediamine,
N,N,N',N'-tetrabutyl-1,3-propylenediamine,
N,N,N',N'-tetraisobutyl-1,3-propylenediamine,
N,N,N',N'-tetramethyl-1,2-butylenediamine,
N,N,N',N'-tetraethyl-1,2-butylenediamine,
N,N,N',N'-tetrapropyl-1,2-butylenediamine,
N,N,N',N'-tetraisopropyl-1,2-butylenediamine,
N,N,N',N'-tetrabutyl-1,2-butylenediamine,
N,N,N',N'-tetraisobutyl-1,2-butylenediamine,
N,N,N',N'-tetramethyl-1,3-butylenediamine,
N,N,N',N'-tetraethyl-1,3-butylenediamine,
N,N,N',N'-tetrapropyl-1,3-butylenediamine,
N,N,N',N'-tetraisopropyl-1,3-butylenediamine,
N,N,N',N'-tetrabutyl-1,3-butylenediamine,
N,N,N',N'-tetraisobutyl-1,3-butylenediamine,
N,N,N',N'-tetrabutyl-1,4-butylenediamine,
N,N,N',N'-tetramethyl-1,4-butylenediamine,
N,N,N',N'-tetraethyl-1,4-butylenediamine,
N,N,N',N'-tetrapropyl-1,4-butylenediamine,
N,N,N',N'-tetraisopropyl-1,4-butylenediamine,
N,N,N',N'-tetrabutyl-1,4-butylenediamine,
N,N,N',N'-tetraisobutyl-1,4-butylenediamine,
N,N,N',N'-tetramethyl-1,5-pentylenediamine,
N,N,N',N'-tetraethyl-1,5-pentylenediamine,
N,N,N',N'-tetramethyl-1,6-hexylenediamine, and
N,N,N',N'-tetraethyl-1,6-hexylenediamine,
and
which further comprises a nonionic surfactant having an alkyleneoxy group, wherein said nonionic surfactant is represented by the following formula (S1) or (S2):

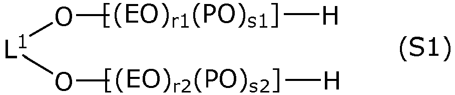

R^{a}O―[(EO)ᵣ₃(PO)ₛ₃]―H (S2)

in which EO and PO represent -(CH₂)₂-O- and -CH₂-CH(CH₃)-O-, respectively, provided that the units of each of EO and PO may combine with each other either randomly or to form a block; L¹ is a 1 to 30 carbon atom-hydrocarbon chain which may contain an unsaturated bond; R^{a} is a saturated or unsaturated hydrocarbon chain of 5 to 30 carbon atoms; each of r1 to r3 and s1 to s3 is an integer of 20 or less for indicating the repeating degree of EO or PO; each of r1+s1 and r2+s2 is independently an integer of 0 to 20 provided that r1+s1+r2+s2 is an integer of 1 or more; and r3+s3 is an integer of 1 to 20, preferably, 2 to 10.

The present invention also resides in a pattern formation method comprising the steps of:
(1) coating a substrate with a photosensitive resin composition to form a photosensitive resin composition layer,
(2) subjecting said photosensitive resin composition layer to exposure,
(3) developing the photosensitive resin composition layer with a developing solution, and
(4) treating the substrate with the above rinse solution for lithography.

### EFFECT OF THE INVENTION

The rinse solution of the present invention for lithography enables to prevent a fine resist pattern, particularly, a miniaturized pattern of ArF resist or of deep UV resist, from collapsing and melting at the same time, and thereby it becomes possible to form a more precise and accurate pattern.

### BEST MODE FOR CARRYING OUT THE INVENTION

Aspects of the present invention are described below in detail. The nitrogen-containing compound is selected from the group consisting of:
N,N,N',N'-tetramethylethylenediamine,
N,N,N',N'-tetraethylethylenediamine,
N,N,N',N'-tetrapropylethylenediamine,
N,N,N',N'-tetraisopropylethylenediamine,
N,N,N',N'-tetrabutylethylenediamine,
N,N,N',N'-tetraisobutylethylenediamine,
N,N,N',N'-tetramethyl-1,2-propylenediamine,
N,N,N',N'-tetraethyl-1,2-propylenediamine,
N,N,N',N'-tetrapropyl-1,2-propylenediamine,
N,N,N',N'-tetraisopropyl-1,2-propylenediamine,
N,N,N',N'-tetrabutyl-1,2-propylenediamine,
N,N,N',N'-tetraisobutyl-1,2-propylenediamine,
N,N,N',N'-tetramethyl-1,3-propylenediamine,
N,N,N',N'-tetraethyl-1,3-propylenediamine,
N,N,N',N'-tetrapropyl-1,3-propylenediamine,
N,N,N',N'-tetraisopropyl-1,3-propylenediamine,
N,N,N',N'-tetrabutyl-1,3-propylenediamine,
N,N,N',N'-tetraisobutyl-1,3-propylenediamine,
N,N,N',N'-tetramethyl-1,2-butylenediamine,
N,N,N',N'-tetraethyl-1,2-butylenediamine,
N,N,N',N'-tetrapropyl-1,2-butylenediamine,
N,N,N',N'-tetraisopropyl-1,2-butylenediamine,
N,N,N',N'-tetrabutyl-1,2-butylenediamine,
N,N,N',N'-tetraisobutyl-1,2-butylenediamine,
N,N,N',N'-tetramethyl-1,3-butylenediamine,
N,N,N',N'-tetraethyl-1,3-butylenediamine,
N,N,N',N'-tetrapropyl-1,3-butylenediamine,
N,N,N',N'-tetraisopropyl-1,3-butylenediamine,
N,N,N',N'-tetrabutyl-1,3-butylenediamine,
N,N,N',N'-tetraisobutyl-1,3-butylenediamine,
N,N,N', N'-tetrabutyl-1,4-butylenediamine,
N,N,N',N'-tetramethyl-1,4-butylenediamine,
N,N,N',N'-tetraethyl-1,4-butylenediamine,
N,N,N',N'-tetrapropyl-1,4-butylenediamine,
N,N,N',N'-tetraisopropyl-1,4-butylenediamine,
N,N,N',N'-tetrabutyl-1,4-butylenediamine,
N,N,N',N'-tetraisobutyl-1,4-butylenediamine,
N,N,N',N'-tetramethyl-1,5-pentylenediamine,
N,N,N',N'-tetraethyl-1,5-pentylenediamine,
N,N,N',N'-tetramethyl-1,6-hexylenediamine, and
N,N,N',N'-tetraethyl-1,6-hexylenediamine.

The nitrogen-containing compounds may be used in combination of two or more.

The rinse solution for lithography according to the present invention comprises water as a solvent, as well as the above nitrogen-containing compound. The water is preferably subjected to distillation, ion-exchange treatment, filtration or various adsorption treatments, so as to remove organic impurities, metal ions and the like. Accordingly, pure water is particularly preferred.

The lithographic rinse solution of the present invention further contains a surfactant. The surfactant improves wettability of the resist surface to the rinse solution, and also it controls the surface tension to prevent the pattern from collapsing and peeling off.

The surfactant is a nonionic surfactant represented by the following formula (S1) or (S2):

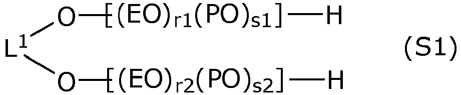

R^{a}O―[(EO)ᵣ₃(PO)ₛ₃]―H (S2)

in which EO and PO represent -(CH₂)₂-O- and -CH₂-CH(CH₃)-O-, respectively, provided that the units of each of EO and PO may combine with each other either randomly or to form a block; L¹ is a 1 to 30 carbon atom-hydrocarbon chain which may contain an unsaturated bond. The hydrocarbon chain L¹ is preferably represented by the following formula: 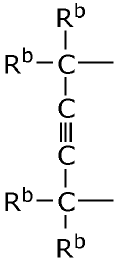 in which each R^{b} is independently a saturated or unsaturated, straight-chain or branched-chain hydrocarbon chain of 3 to 10 carbon atoms, provided that a hydrogen atom connecting to the carbon atom constituting said hydrocarbon chain may be substituted with -OH. The R^{a} is a saturated or unsaturated hydrocarbon chain of 5 to 30 carbon atoms. Each of r1 to r3 and s1 to s3 is an integer of 20 or less for indicating the repeating degree of EO or PO, and each of r1+s1 and r2+s2 is independently an integer of 0 to 20 provided that r1+s1+r2+s2 is an integer of 1 or more. Each of r1+s1 and r2+s2 is preferably an integer of 2 to 10, and r3+s3 is an integer of 1 to 20, preferably 2 to 10.

Since strongly preventing the pattern from melting, the above surfactant preferably has high hydrophobicity. Accordingly, L¹ or R^{a} preferably contains many carbon atoms and the group EO or PO is preferably less repeated because the groups L¹ and R^{a} are hydrophobic and the groups EO and PO are relatively hydrophilic.

Two or more surfactants can be used in combination, if necessary.

The rinse solution for lithography according to the present invention may further contain various additives, if necessary. Examples of the additives include acids, bases, and organic solvents.

The acids or bases may be incorporated for controlling the pH value of the solution or for improving the solubility of each component. Any acid or base can be selected to use unless it impairs the effect of the present invention. They are, for example, carboxylic acids, amines or ammonium salts. They include fatty acids, aromatic carboxylic acids, primary amines, secondary amines, tertiary amines and ammonium compounds, each of which may be substituted with any substituent. Concrete examples of them include formic acid, acetic acid, propionic acid, benzoic acid, phthalic acid, salicylic acid, lactic acid, malic acid, citric acid, oxalic acid, malonic acid, succinic acid, fumaric acid, maleic acid, aconitic acid, glutaric acid, adipic acid, monoethanolamine, diethanolamine, triethanolamine, triisopropanolamine and tetramethylammonium.

In addition to water, an organic solvent can be used as a co-solvent. The organic solvent may have functions of controlling the surface tension of the rinse solution and of improving the wettability thereof to the resist surface. The solvent used for this purpose is selected from water-soluble organic solvents. Examples of the organic solvent include: alcohols such as methanol, ethanol iso-propanol and t-butanol; glycols, such as ethylene glycol or diethyleneglycol; ketones such as acetone and methyl ethyl ketone; and esters such as methyl acetate, ethyl acetate and ethyl lactate; dimethyl formamide, dimethyl sulfoxide, methyl cellosolve, cellosolve, butyl cellosolve, cellosolve acetate, alkyl cellosolve acetate, propylene glycol alkyl ether, propylene glycol alkyl ether acetate, butyl carbitol, carbitol acetate, and tetrahydrofuran.

However, the above organic solvent may dissolve or denature the resist of the pattern, and accordingly it must be incorporated in a small amount, if used. The amount thereof is normally 15 weight parts or less but preferably not less than 0.1wt% based on the total weight of said rinse solution. For the purpose of keeping the resist from being dissolved or denatured, it is preferred not to use the organic solvent at all.

In addition the lithographic rinse solution may comprise a preservative, bactericidal and/or fungicidal agent. These agents are employed in order to avoid the growth of bacteria or fungi in an aging rinse solution. Examples include alcohols, such as phenoxyethanol, or isothiazolones, and the like. Notably useful are the preservatives, fungicides and bactericides marketed under the tradename BestCide provided by Nippon Soda Co. Typically, these agents do not have any effect on the performance of the lithographic rinse solution and are added in amount of not more than 1wt%, preferably less than 0.1 wt% but preferably not less than 0.001wt%.

The lithographic rinse solution of the present invention comprises water as a solvent and other components dissolved therein. The content of each component is freely determined according to the use of the rinse solution, the kind of the resist to be treated and the solubility of each component. If containing the nitrogen-containing compound in a large amount, the rinse solution generally shows large effect on improving the pattern collapse. On the other hand, however, if containing the nitrogen-containing compound in a small amount, the rinse solution tends to show large effect on improving the melting. In practice, therefore, the content is properly determined in view of the balance between them. For example, the content of the nitrogen-containing compound is not less than 0.005%, but not more than 5%, based on the total weight of the solution. The nitrogen-containing compound is incorporated in an amount of preferably not less than 0.005%, more preferably not less than 0.01%, and preferably not more than 1%, more preferably not more than 0.5%, based on the total weight of the solution. Further, the content of the surfactant is generally not less than 0.01%, preferably not less than 0.03%, more preferably not less than 0.1%, and generally not more than 10%, preferably not more than 1%, more preferably not more than 0.5%, based on the total weight of the solution. In either case, water, the nitrogen-containing compound and the surfactant are main components and hence the rinse solution contains other components in an amount of preferably 1 % or less, more preferably 0.5 % or less, based on the total weight of the solution.

The pattern formation method according to the present invention is described below in detail. In the pattern formation method of the present invention, there is no particular restriction on the lithographic process. Accordingly, the lithographic process can be carried out in any known manner of forming a resist pattern from a conventional positive- or negative-working photosensitive resin composition. The following describes a typical pattern formation method employing the lithographic rinse solution of the present invention.

First, a photosensitive resin composition is coated on a surface, which may be pretreated, if necessary, of a substrate, such as a silicon substrate or a glass substrate, according to a known coating method such as spin-coating method, to form a photosensitive resin composition layer. Prior to the coating of the photosensitive resin composition, an antireflection film can be beforehand formed under or above the resist by coating. The antireflection film can improve the section shape and the exposure margin.

Any known photosensitive resin composition can be used in the pattern formation method of the present invention. Representative examples of the compositions usable in the present invention include: a composition comprising a quininediazide type photosensitive substance and an alkali-soluble resin, a chemically amplified photosensitive resin composition (which are positive-working compositions); a composition comprising a photosensitive functional group-containing polymer such as polyvinyl cinnamate, a composition comprising an azide compound such as an aromatic azide compound or a bisazide compound with a cyclized rubber, a composition comprising a diazo resin, a photo-polymerizable composition comprising an addition-polymerizable unsaturated compound, and a chemically amplified negative-working photosensitive resin composition (which are negative-working compositions).

Examples of the quinonediazide type photosensitive substance used in the positive-working composition comprising a quinonediazide type photosensitive substance and an alkali-soluble resin include: 1,2-benzoquinonediazide-4-sufonic acid, 1,2-naphthoquinonediazide-4-sufonic acid, 1,2-naphthoquinonediazide-5-sufonic acid, and sufonic esters or amides thereof. Examples of the alkali-soluble resin include: novolak resin, polyvinyl phenol, polyvinyl alcohol, and copolymers of acrylic acid or methacrylic acid. The novolak resin is preferably prepared from one or more phenols such as phenol, o-cresol, m-cresol, p-cresol and xylenol in combination with one or more aldehydes such as formaldehyde and paraformaldehyde.

Either positive- or negative-working chemically amplified photosensitive resin composition can be used in the pattern formation method of the present invention. The chemically amplified resist generates an acid when exposed to radiation, and the acid serves as a catalyst to promote chemical reaction by which solubility to the developing solution is changed within the areas irradiated with the radiation to form a pattern. For example, the chemically amplified photosensitive resin composition comprises an acid-generating compound, which generates an acid when exposed to radiation, and an acid-sensitive functional group-containing resin, which decomposes in the presence of acid to form an alkali-soluble group such as phenolic hydroxyl or carboxyl group. The composition may comprise an alkali-soluble resin, a crosslinking agent and an acid-generating compound.

The photosensitive resin composition layer formed on the substrate is prebaked, for example, on a hot plate to remove solvent contained in the composition, to form a photoresist film of normally 0.5 to 2.5 µm thickness. The prebaking temperature depends on the solvent and the photosensitive resin composition, but is normally 20 to 200°C, preferably 50 to 150°C.

The photoresist film is then subjected to exposure through a mask, if necessary, by means of known exposure apparatus such as a high-pressure mercury lamp, a metal halide lamp, an ultra-high pressure mercury lamp, a KrF excimer laser, an ArF excimer laser, a soft X-ray irradiation system, and an electron beam lithography system.

After the exposure, baking treatment may be carried out, if necessary, and then development such as paddle development is carried out to form a resist pattern. The resist is normally developed with an alkaline developing solution. Examples of the alkaline developing solution include an aqueous solution of sodium hydroxide or tetramethylammonium hydroxide (TMAH). After the development, the resist pattern is rinsed (washed) with the rinse solution. The thus-formed resist pattern is employed as a resist for etching, plating, ion diffusion or dyeing, and then, if necessary, peeled away.

According to the pattern formation method of the present invention, even a pattern of high fineness and of high aspect ratio can be effectively prevented from collapsing and melting. Here, the term "aspect ratio" means the ratio of height to width in the resist pattern. Accordingly, the method of the present invention is preferably combined with a lithographic process capable of giving a fine resist pattern, such as, a lithographic process comprising exposure at a wavelength of 250 nm or shorter by use of a light source of a KrF excimer laser, an ArF excimer laser, an X-ray irradiation system or an electron beam lithography system. Further, the lithographic process preferably produces a resist pattern having a pattern dimension in which a line width of the line-and-space pattern or a hole diameter of the contact hole pattern is not more than 300 nm, preferably not more than 50 nm.

In the pattern formation method according to the present invention, the resist pattern after developed is treated with the aforementioned rinse solution for lithography. There is no particular restriction on how long the resist substrate is in contact with the rinse solution for lithography, namely, on the treating time. However, the treating time is generally not less than 1 second so as to obtain the effect of the present invention. There is also no particular restriction on how the resist is brought into contact with the rinse solution. For example, the resist substrate may be immersed in the rinse solution, or otherwise the rinse solution may be dropped or sprayed onto the resist substrate while the substrate is being spun.

Further, the pattern formation method of the present invention may comprise washing procedure with pure water after the development. The developed resist pattern may be washed with pure water before and/or after treated with the rinse solution for lithography according to the present invention. The washing with pure water before the treatment with the rinse solution is for the purpose of washing out the developing solution remaining on the resist pattern, and that after the treatment is for the purpose of washing out the rinse solution. The washing with pure water can be carried out in any manner. For example, the resist substrate may be immersed in pure water, or otherwise pure water may be dropped or sprayed onto the resist substrate while the substrate is being spun. The washing with pure water can be performed either or both of before and after the treatment. The washing after the development is preferred because it removes residues of the resist and the developing solution remaining on the substrate and thereby enhances the effect of the invention. On the other hand, the washing after the treatment can remove the rinse solution. Particularly in the case where the resist pattern is treated with the rinse solution of more than 1 % concentration, the washing with pure water after the treatment sometimes enables the present invention to show the best effect because it enhances the effect on improvement in preventing the melting.

It is not completely clear at present why the prevention of melting is improved by treating the developed resist with the rinse solution for lithography according to the present invention. However, it is presumed to be as follows.

On the resist substrate after developed, many deprotected carboxylic acid groups are thought to remain. When brought into contact with an aqueous solution such as a common rinse solution, the carboxylic acid groups are ionized and hence the resist becomes water-soluble to cause the melting. However, if the resist is treated with the rinse solution of the present invention, the carboxylic acid groups react and combine with the nitrogen-containing compound. Since the formed structure is similar to an organic salt, the combined carboxylic acid groups are hard to be ionized and accordingly the resultant resist has a relatively low solubility to aqueous solutions. As a result, the rinse solution of the present invention improves the prevention of melting. In the above mechanism, the nitrogen-containing compound combines with the carboxylic acid group at the hydrophobic moiety, namely, at the hydrocarbon chain. Accordingly, the longer hydrocarbon chain the compound has, the more strongly the present invention tends to improve the prevention of melting.

In the case where the nitrogen-containing compound has two or more basic groups in a molecule, plural carboxylic acid groups on the resist substrate are crosslinked to improve the prevention of melting. Accordingly, the more basic groups the compound has in a molecule, the more the resist is hardened.

On the other hand, if having a low molecular weight, the nitrogen-containing compound in the rinse solution soaks from the resist surface into the inside when the resist pattern is treated with the rinse solution. Since the compound soaking into the resist can combine with the carboxylic acid groups inside of the resist, the prevention of melting is also enhanced.

The present invention is further explained by use of the following examples, but they by no means restrict embodiments of the present invention.

### Comparative Example A101

A silicon substrate was coated with a bottom anti-reflection layer-forming composition of KrF exposure type (KrF-17B [trademark], manufactured by AZ Electronic Materials (Japan) K.K.), to form an anti-reflection layer of 80 nm thickness. After that, an ArF resist composition (DX6270 [trademark], manufactured by AZ Electronic Materials (Japan) K.K.) was spread thereon to form a layer of 620 nm thickness, and then subjected to baking at 130°C for 90 seconds to prepare a substrate having a resist layer. The obtained substrate was subjected to exposure by means of a KrF exposure apparatus (FPA-EX5 [trademark], manufactured by Canon Inc.), and thereafter developed to produce a developed resist substrate having line patterns. In the exposure step, the exposure conditions were so varied that the line width might be changed to form plural patterns of different aspect ratios.

The formed patterns were observed to estimate the maximum aspect ratio that did not cause pattern collapse. As a result of Comparative Example A101, the aspect ratio was 3.0 that did not cause pattern collapse.

Successively, melting behavior of the formed patterns was also evaluated. The substrate was placed in a furnace and heated at 130°C for 70 seconds, and then the patterns were observed and found to be slightly melted.

### Comparative Examples A102 to A105 and Reference Examples A101 to A108

In addition to the procedure of Comparative Example A101, a rinse treatment was performed by use of a rinse solution after the development. The substrate was then evaluated. Specifically, after the developed resist pattern was washed with pure water, the rinse treatment was carried out by dipping the resist pattern into the rinse solution for 8 to 10 seconds. The rinse solution contained each nitrogen-containing compound shown in Table 1. The results were as set forth in Table 1.

### [Table 1]

**Table 1**

| | Rinse solution | | Pattern collapse | | Melting |
|---|---|---|---|---|---|
| | Nitrogen-containing compound | Concentration (%) | (a/r) | Grade | Grade |
| Com. A101 | - | - | 3.0 | C | A |
| Com. A102 | ammonia | 0.6 | 3.0 | C | C |
| Com. A103 | methylamine | 0.6 | 3.1 | C | C |
| Com. A104 | dimethyl-amine | 0.6 | 3.1 | C | C |
| Com. A105 | trimethylamine | 0.6 | 3.2 | C | B |
| Ref. Ex. A101 | i-butyl-amine | 0.6 | 4.0 | A | B |
| Ref. Ex. A102 | t-octylamine | 0.6 | 4.5 | A | B |
| Ref. Ex. A103 | tetramethylethylenediamine | 0.6 | 4.8 | A | A |
| Ref. Ex. A104 | tetraethylethylene-diamine | 0.6 | 5.0 | A | A |
| Ref. Ex. A105 | tetraethylpropylenediamine | 0.6 | 5.1 | A | A |
| Ref. Ex. A106 | tetraethylbutylenediamine | 0.6 | 5.0 | A | A |
| Ref. Ex. A107 | tetra methylhexylenediamine | 0.6 | 5.0 | A | A |
| Ref. Ex. A108 | tetraethylpropane-diamine | 0.6 | 5.1 | A | A |

### Remarks:

tetramethylethylenediamine=
   N,N,N',N'-tetramethylethylenediamine,
tetraethylethylenediamine=
   N,N,N',N'-tetraethylethylenediamine,
tetramethylpropylenediamine=
   N,N,N',N'-tetramethyl-1,3-propylenediamine,
tetraethylbutylenediamine=
   N,N,N',N'-tetraethyl-1,4-butylenediamine,
tetramethylhexylenediamine=
   N,N,N',N'-tetramethyl-1,6-hexylenediamine,
tetraethylpropanediamine=
   N,N,N',N'-tetraethyl-1,3-propylenediamine.

In Table 1, the pattern collapse was evaluated and classified into the following grades:
A: the pattern collapse was caused in an aspect ratio of more than 4.0, and hence was remarkably improved;
B: the pattern collapse was caused in an aspect ratio of 3.4 to 4.0, and hence was slightly improved; and
C: the pattern collapse was caused in an aspect ratio of less than 3.4, and hence was hardly or not at all improved.

Further in Table 1, the melting was also evaluated and classified into the following grades:
A: the melting was not at all caused;
B: the melting was slightly caused but negligible from the practical viewpoint; and
C: the melting was so seriously caused that the pattern was impossible to use practically.

### Comparative Example A201 to 206 and Reference Examples 201 to 204

The procedure of Comparative Example A101 was repeated except for using a rinse solution containing trimethylamine or N,N,N',N'-tetramethylethylenediamine as the nitrogen-containing compound, to evaluate the patterns. The concentration of the nitrogen-containing compound was varied as shown in Table 2. The results were as set forth in Table 2.

### [Table 2]

**Table 2**

| | Rinse solution | | Pattern collapse | | Melting |
|---|---|---|---|---|---|
| | Nitrogen-containing compound | Concentration (%) | (a/r) | Grade | Grade |
| Com. A201 | - | - | 3.0 | C | A |
| Com. A202 | trimethylamine | 0.1 | 3.1 | B | B |
| Com. A203 | trimethylamine | 0.5 | 3.3 | B | B |
| Com. A204 | trimethyl-amine | 1.0 | 3.6 | B | B |
| Com. A205 | trimethylamine | 2.0 | 3.8 | B | C |
| Com. A206 | trimethylamine | 4.0 | 4.0 | A | C |
| Ref. Ex. A201 | tetramethylethylenediamine | 0.1 | 4.6 | A | A |
| Ref. Ex. A202 | tetramethylethylenediamine | 0.5 | 4.8 | A | A |
| Ref. Ex. A203 | tetramethylethylenediamine | 1.0 | 4.9 | A | A |
| Ref. Ex. A204 | tetramethylethylenediamine | 2.0 | 5.0 | A | A |

In Table 2, the grades of the melting are the same as those in Table 1.

### Comparative Examples B101 to B104 and Examples B101 to B104

The procedure of Comparative Example A101 was repeated except for using a rinse solution containing a nitrogen-containing compound and/or a nonionic surfactant, to evaluate the patterns. As the nitrogen-containing compound, N,N,N',N'-tetramethylethylenediamine was used. The nonionic surfactant was a compound represented by the following formula (S-1), (S-2) or (S-3). The results were as set forth in Table 3.

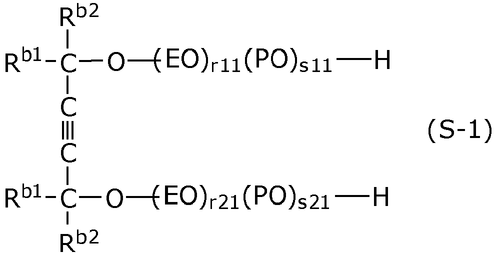

_{R}^{a2}-O―(EO)ᵣ₁₂―H (S-2)

R^{a3}-O―(EO)ᵣ₁₃(PO)ₛ₁₃―H (S-3)

In the above formulas, R^{b1} is methyl and R^{b2} is isbutyl and r11, s11, r21 and s21 are integers satisfying the conditions of r11+r21 = 5, s11+s21 = 2, respectively; R^{a2} is C₁₈H₃₇ and r12 is an integer satisfying the condition of r12= 15; and R^{a3} is C₁₈H₃₇ and r13 and s13 are integers satisfying the conditions of r13= 10 and s13= 5, respectively.

### [Table 3]

| Table 3 | | | | | | |
|---|---|---|---|---|---|---|
| | Rinse solution | | | Pattern collapse | | Melting |
| | tetramethylethylenediamine | Surfactant | | | | |
| | Concentration (%) | Compound | Concen-tration (%) | (a/r) | Grade | Grade |
| Com. B101 | - | - | - | 3.0 | C | A |
| Com. B102 | - | S-1 | 0.5 | 4.8 | B | C |
| Com. B103 | - | S-2 | 0.5 | 4.3 | B | C |
| Com. B104 | - | S-3 | 0.5 | 4.0 | B | C |
| Ex. B101 | 0.5 | S-1 | 0.5 | 5.2 | A | A |
| Ex. B102 | 0.5 | S-2 | 0.5 | 4.9 | B | B |
| Ex. B103 | 0.5 | S-3 | 0.5 | 4.9 | B | B |
| Ex. B104 | 0.5 | S-1 | 1.0 | 5.5 | A | A |

### Comparative Examples B201 to B202, Reference Examples B201 to B215 and Examples B201 to B205

A silicon substrate was coated with a bottom anti-reflection layer-forming composition of ArF exposure type (ArF1C5D [trademark], manufactured by AZ Electronic Materials (Japan) K.K.), to form an anti-reflection layer of 37 nm thickness. After that, an ArF resist composition (AX2110P [trademark], manufactured by AZ Electronic Materials (Japan) K.K.) was spread thereon to form a layer of 90 nm thickness, and then subjected to baking at 110°C for 60 seconds to prepare a substrate having a resist layer. The obtained substrate was subjected to exposure by means of an ArF exposure apparatus (NSR-S306C [trademark], manufactured by Nikon Corporation), and thereafter developed to produce a developed resist substrate having line patterns. In the exposure step, the exposure conditions were so varied that the line width might be changed to form plural patterns of different aspect ratios (Comparative Example B101). With respect to the pattern collapse and the melting, the sample of Comparative Example B101 was evaluated in the same manner as in Comparative Example A101.

Further, the procedure of Comparative Example B101 was repeated except for using a rinse solution containing a nitrogen-containing compound and/or a nonionic surfactant, to evaluate the patterns. As the nonionic surfactant, the nonionic surfactant (S-1) was used. The nitrogen-containing compound used in each Example was shown in Table 4. The results were as set forth in Table 4.

### [Table 4]

**Table 4**

| | Rinse solution | | Pattern collapse | | | Melting |
|---|---|---|---|---|---|---|
| | Nitrogen-containing compound | | S-1 | (a/r) | Grade | Grade |
| | Compound | Concentration (%) | Concentration (%) | | | |
| Com. B201 | - | - | - | 3.0 | C | A |
| Com. B202 | - | - | 0.2 | 4.8 | A | C |
| Ref. Ex. B201 | mono-ethanol-amine | 0.2 | 0.2 | 5.5 | A | A |
| Ref. Ex. B202 | triethanol-am ine | 0.2 | 0.2 | 5.1 | A | C |
| Ref. Ex. B203 | iso-butyl-amine | 0.2 | 0.2 | 5.3 | A | B |
| Ref. Ex. B204 | di-i-butyl-amine | 0.2 | 0.2 | 4.8 | A | B |
| Ref. Ex. B205 | tri-i-butyl-amine | 0.2 | 0.2 | 5.4 | A | A |
| Ref. Ex. B206 | dimethyl-formamide | 0.2 | 0.2 | 5.4 | A | B |
| Ref. Ex. B207 | trifluoro-acetamide | 0.2 | 0.2 | 5.4 | A | A |
| Ref. Ex. B208 | dimethyl-acetamide | 0.2 | 0.2 | 4.8 | A | A |
| Ref. Ex. B209 | piperidine-1-carboaldehyde | 0.2 | 0.2 | 5.1 | A | A |
| Ref. Ex. B210 | polyallyl-amine | 0.2 | 0.2 | 4.8 | A | B |
| Ref. Ex. B211 | 2-diethyl-aminoethanol | 0.2 | 0.2 | 5.1 | A | A |
| Ref. Ex. B212 | 4-hydroxy-piperidine | 0.2 | 0.2 | 5.5 | A | A |
| Ref. Ex. B213 | N-(2-amino-ethyl)-piperazine | 0.2 | 0.2 | 5.3 | A | A |
| Ref. Ex. B214 | N-(3-amino-propyl)-morpholine | 0.2 | 0.2 | 5.2 | A | A |
| Ref. Ex. B215 | tetra-methylethylene-diamine | 0.2 | 0.2 | 5.4 | A | A |
| Ex. B201 | tetraethyl-ethylenediamine | 0.2 | 0.2 | 5.4 | A | A |
| Ex. B202 | tetra-methylpropylene-diamine | 0.2 | 0.2 | 5.5 | A | A |
| Ex. B203 | tetraethyl-butylenediamine | 0.2 | 0.2 | 5.5 | A | A |
| Ex. B204 | tetra-methylhexylene-diamine | 0.2 | 0.2 | 5.5 | A | A |
| Ex. B205 | tetraethyl-propanediamine | 0.2 | 0.2 | 5.5 | A | A |

### Examples C101 and C102

The following example shows that the addition of a bactericidal agent improves the shelf life of the lithographic rinse solution.

Two liter of the formulation of Example B202 was divided in two equal parts (C101 and C102). To formulation C102 was added 0.2 g of a 5% aqueous solution of Bestcide 600C, (a commercial bactericide manufactured by Nisso Chemical). Each of these two solutions was divided in nine parts, and left in open beakers for 12 hours. Subsequently, the beakers were tightly closed and stored for a certain period at a certain temperature as detailed in table 5. After that the solutions examined for bacteria using a proprietary incubation protocol from Nomura Microscience. The bacteria counts revealed that the material including the bactericide (C102) did have a significantly longer shelf life than the solution having no bactericide (C101).

### Table 5

**Table 5**

| | Temperature (°C) | Storage Period | | |
|---|---|---|---|---|
| | | 1 month | 3 months | 6 months |
| Ex. C101 | 5 | > 10 | > 10 | > 100 |
| | 25 | > 100 | > 1000 | > 1000 |
| | 40 | > 10 | > 100 | > 100 |
| Ex. C102 | 5 | 0 | 0 | 0 |
| | 25 | 0 | 1 | 0 |
| | 40 | 0 | 0 | 2 |

### Comparison Example D101 and Example D102

One liter of the rinse solution was prepared by the same preparation as B203 except for changing the concentration of N,N,N',N'-tetrabutyl ethylenediamene to 1.0%. The solution was then divided into two equal parts (D101 and D102), and 10 ml isopropanol was added to D102, while 10 ml water was added to D101. Both solutions were mixed well, placed into closed glass bottles and left alone at RT for seven days. Visual inspection of the bottles indicated that in both cases clear solutions were obtained.

However, when each of the two rinse solutions was hand dispensed on a resist coated, but unexposed 8 inch wafer, prepared as outlined in comparative example A101, visual inspection of the wafer surface revealed that the wetting was improved when a solution of D102 was coated on the resist.

## Claims

1. A rinse solution for lithography, which comprises water, at least one nitrogen-containing compound selected from the group consisting of the compounds
N,N,N',N'-tetramethylethylenediamine,
N,N,N',N'-tetraethylethylenediamine,
N,N,N',N'-tetrapropylethylenediamine,
N,N,N',N'-tetraisopropylethylenediamine,
N,N,N',N'-tetrabutylethylenediamine,
N,N,N',N'-tetraisobutylethylenediamine,
N,N,N',N'-tetramethyl-1,2-propylenediamine,
N,N,N',N'-tetraethyl-1,2-propylenediamine,
N,N,N',N'-tetrapropyl-1,2-propylenediamine,
N,N,N',N'-tetraisopropyl-1,2-propylenediamine,
N,N,N',N'-tetrabutyl-1,2-propylenediamine,
N,N,N',N'-tetraisobutyl-1,2-propylenediamine,
N,N,N',N'-tetramethyl-1,3-propylenediamine,
N,N,N',N'-tetraethyl-1,3-propylenediamine,
N,N,N',N'-tetrapropyl-1,3-propylenediamine,
N,N,N',N'-tetraisopropyl-1,3-propylenediamine,
N,N,N',N'-tetrabutyl-1,3-propylenediamine,
N,N,N',N'-tetraisobutyl-1,3-propylenediam ine,
N,N,N',N'-tetramethyl-1,2-butylenediamine,
N,N,N',N'-tetraethyl-1,2-butylenediamine,
N,N,N',N'-tetrapropyl-1,2-butylenediamine,
N,N,N',N'-tetraisopropyl-1 ,2-butylenediamine,
N,N,N',N'-tetrabutyl-1,2-butylenediamine,
N,N,N',N'-tetraisobutyl-1,2-butylenediamine,
N,N,N',N'-tetramethyl-1,3-butylenediamine,
N,N,N',N'-tetraethyl-1,3-butylenediamine,
N,N,N',N'-tetrapropyl-1,3-butylenediamine,
N,N,N',N'-tetraisopropyl-1,3-butylenediamine,
N,N,N',N'-tetrabutyl-1,3-butylenediamine,
N,N,N',N'-tetraisobutyl-1,3-butylenediamine,
N,N,N',N'-tetrabutyl-1,4-butylenediamine,
N,N,N',N'-tetramethyl-1,4-butylenediamine,
N,N,N',N'-tetraethyl-1,4-butylenediamine,
N,N,N',N'-tetrapropyl-1,4-butylenediamine,
N,N,N',N'-tetraisopropyl-1,4-butylenediamine,
N,N,N',N'-tetrabutyl-1,4-butylenediamine,
N,N,N',N'-tetraisobutyl-1,4-butylenediamine,
N,N,N',N'-tetramethyl-1,5-pentylenediamine,
N,N,N',N'-tetraethyl-1,5-pentylenediamine,
N,N,N',N'-tetramethyl-1,6-hexylenediamine, and
N,N,N',N'-tetraethyl-1,6-hexylenediamine,
and which further comprises a nonionic surfactant having an alkyleneoxy group, wherein said nonionic surfactant is represented by the following formula (S1) or (S2): 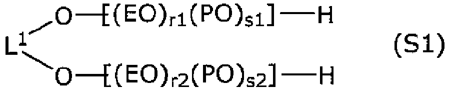
R^{a}O―[(EO)ᵣ₃(PO)ₛ₃]―H (S2)
in which EO and PO represent -(CH₂₎₂-O- and -CH₂-CH(CH₃)-O-, respectively, provided that the units of each of EO and PO may combine with each other either randomly or to form a block; L¹ is a 1 to 30 carbon atom-hydrocarbon chain which may contain an unsaturated bond; R^{a} is a saturated or unsaturated hydrocarbon chain of 5 to 30 carbon atoms; each of r1 to r3 and s1 to s3 is an integer of 20 or less for indicating the repeating degree of EO or PO; each of r1+s1 and r2+s2 is independently an integer of 0 to 20 provided that r1+s1+r2+s2 is an integer of 1 or more; and r3+s3 is an integer of 1 to 20, preferably, 2 to 10.

2. The rinse solution for lithography according to claim 1, wherein the content of said nitrogen-containing compound is not less than 0.005% but not more than 5 % based on the total weight of said rinse solution.

3. The rinse solution for lithography according to claim 1 or 2, wherein the content of said nonionic surfactant is 0.01 to 10 wt% based on the total weight of said rinse solution.

4. The rinse solution for lithography according to any of claims 1 to 3, which further comprises a bactericidal, bacteriostatic, preservative, or fungicidal agent.

5. The rinse solution for lithography according to claim 4, wherein the content of bactericidal, bacteriostatic, preservative, or fungicidal agent is not less than 0.001wt% to not more than 1 wt% based on the total weight of said rinse solution.

6. The rinse solution for lithography according to any of claims 1 to 5, which further comprises a water mixable or water soluble co-solvent.

7. The rinse solution for lithography according to claim 6, wherein the content of co-solvent is not less than 0.1wt% to not more than 15wt% based on the total weight of said rinse solution.

8. A pattern formation method comprising the steps of:
(1) coating a substrate with a photosensitive resin composition to form a photosensitive resin composition layer,
(2) subjecting said photosensitive resin composition layer to exposure,
(3) developing the photosensitive resin composition layer with a developing solution, and
(4) treating the substrate with the rinse solution for lithography according to any of claims 1 to 7.

## Patentansprüche

1. Spüllösung für die Lithographie, die Wasser, mindestens eine stickstoffhaltige Verbindung, ausgewählt aus der Gruppe bestehend aus den Verbindungen
N,N,N',N'-Tetramethylethylendiamin,
N,N,N',N'-Tetraethylethylendiamin,
N,N,N',N'-Tetrapropylethylendiamin,
N,N,N',N'-Tetraisopropylethylendiamin,
N,N,N',N'-Tetrabutylethylendiamin,
N,N,N',N'-Tetraisobutylethylendiamin,
N,N,N',N'-Tetramethyl-1,2-propylendiamin,
N,N,N',N'-Tetraethyl-1,2-propylendiamin,
N,N,N',N'-Tetrapropyl-1,2-propylendiamin,
N,N,N',N'-Tetraisopropyl-1,2-propylendiamin,
N,N,N',N'-Tetrabutyl-1,2-propylendiamin,
N,N,N',N'-Tetraisobutyl-1,2-propylendiamin,
N,N,N',N'-Tetramethyl-1,3-propylendiamin,
N,N,N',N'-Tetraethyl-1,3-propylendiamin,
N,N,N',N'-Tetrapropyl-1,3-propylendiamin,
N,N,N',N'-Tetraisopropyl-1,3-propylendiamin,
N,N,N',N'-Tetrabutyl-1,3-propylendiamin,
N,N,N',N'-Tetraisobutyl-1,3-propylendiamin,
N,N,N',N'-Tetramethyl-1,2-butylendiamin,
N,N,N',N'-Tetraethyl-1,2-butylendiamin,
N,N,N',N'-Tetrapropyl-1,2-butylendiamin,
N,N,N',N'-Tetraisopropyl-1,2-butylendiamin,
N,N,N',N'-Tetrabutyl-1,2-butylendiamin,
N,N,N',N'-Tetraisobutyl-1,2-butylendiamin,
N,N,N',N'-Tetramethyl-1,3-butylendiamin,
N,N,N',N'-Tetraethyl-1,3-butylendiamin,
N,N,N',N'-Tetrapropyl-1,3-butylendiamin,
N,N,N',N'-Tetraisopropyl-1,3-butylendiamin,
N,N,N',N'-Tetrabutyl-1,3-butylendiamin,
N,N,N',N'-Tetraisobutyl-1,3-butylendiamin,
N,N,N',N'-Tetrabutyl-1,4-butylendiamin,
N,N,N',N'-Tetramethyl-1,4-butylendiamin,
N,N,N',N'-Tetraethyl-1,4-butylendiamin,
N,N,N',N'-Tetrapropyl-1,4-butylendiamin,
N,N,N',N'-Tetraisopropyl-1,4-butylendiamin,
N,N,N',N'-Tetrabutyl-1,4-butylendiamin,
N,N,N',N'-Tetraisobutyl-1,4-butylendiamin,
N,N,N',N'-Tetramethyl-1,5-pentylendiamin,
N,N,N',N'-Tetraethyl-1,5-pentylendiamin,
N,N,N',N'-Tetramethyl-1,6-hexylendiamin, und
N,N,N',N'-Tetraethyl-1,6-hexylendiamin,
und
die ferner ein nichtionisches Tensid mit einer Alkylenoxygruppe umfasst, wobei das nichtionische Tensid durch die folgende Formel (S1) oder (S2) dargestellt wird: 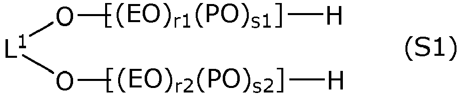
R^{a}O―[(EO)ᵣ₃(PO)ₛ₃]―H (S2)
worin EO und PO für -(CH₂)₂-O- bzw. -CH₂-CH(CH₃)-O- stehen, mit der Maßgabe, daß die Einheiten von EO und PO sich entweder zufällig oder unter Bildung eines Blocks miteinander verbinden können; L¹ eine 1 bis 30 Kohlenstoffatome enthaltende Kohlenwasserstoffkette ist, die eine ungesättigte Bindung enthalten kann; R^{a} eine gesättigte oder ungesättigte Kohlenwasserstoffkette mit 5 bis 30 Kohlenstoffatomen ist; jedes von r1 bis r3 und s1 bis s3 eine ganze Zahl von 20 oder weniger ist, um den Wiederholungsgrad von EO oder PO anzuzeigen; jedes von r1+s1 und r2+s2 unabhängig eine ganze Zahl von 0 bis 20 ist, vorausgesetzt, daß r1+s1+r2+s2 eine ganze Zahl von 1 oder mehr ist; und r3+s3 eine ganze Zahl von 1 bis 20, vorzugsweise 2 bis 10 ist.

2. Spüllösung für die Lithographie nach Anspruch 1, wobei der Gehalt an der stickstoffhaltigen Verbindung nicht weniger als 0,005 %, aber nicht mehr als 5 %, bezogen auf das Gesamtgewicht der Spüllösung, beträgt.

3. Spüllösung für die Lithographie nach Anspruch 1 oder 2, wobei der Gehalt an dem nichtionischen Tensid 0,01 bis 10 Gew.-%, bezogen auf das Gesamtgewicht der Spüllösung, beträgt.

4. Spüllösung für die Lithographie nach einem der Ansprüche 1 bis 3, die außerdem ein bakterizides, bakteriostatisches, konservierendes oder fungizides Mittel enthält.

5. Spüllösung für die Lithographie nach Anspruch 4, wobei der Gehalt an bakterizidem, bakteriostatischem, konservierendem oder fungizidem Mittel nicht weniger als 0,001 Gew.-% bis nicht mehr als 1 Gew.-%, bezogen auf das Gesamtgewicht der Spüllösung, beträgt.

6. Spüllösung für die Lithographie nach einem der Ansprüche 1 bis 5, die außerdem ein mit Wasser mischbares oder wasserlösliches Co-Lösungsmittel enthält.

7. Spüllösung für die Lithographie nach Anspruch 6, wobei der Gehalt an Co-Lösungsmittel nicht weniger als 0,1 Gew.-% bis nicht mehr als 15 Gew.-%, bezogen auf das Gesamtgewicht der Spüllösung, beträgt.

8. Verfahren zur Bildung von Mustern, umfassend die Schritte:
(1) Beschichten eines Substrats mit einer lichtempfindlichen Harzzusammensetzung, um eine lichtempfindliche Harzzusammensetzungsschicht zu bilden,
(2) Aussetzen der lichtempfindlichen Harzzusammensetzungsschicht einer Belichtung,
(3) Entwickeln der lichtempfindlichen Harzzusammensetzungsschicht mit einer Entwicklungslösung, und
(4) Behandeln des Substrats mit der Spüllösung für die Lithographie nach einem der Ansprüche 1 bis 7.

## Revendications

1. Solution de rinçage pour la lithographie, qui comprend de l'eau, au moins un composé contenant de l'azote étant choisi dans le groupe constitué par les composés
N,N,N',N'-tétraméthyléthylènediamine,
N,N,N',N'-tétraéthyléthylènediamine,
N,N,N',N'-tétrapropyléthylènediamine,
N,N,N',N'-tétraisopropyléthylènediamine,
N,N,N',N'-tétrabutyléthylènediamine,
N,N,N',N'-tétraisobutyléthylènediamine,
N,N,N',N'-tétraméthyl-1,2-propylènediamine,
N,N,N',N'-tétraéthyl-1,2-propylènediamine,
N,N,N',N'-tétrapropyl-1,2-propylènediamine,
N,N,N',N'-tétraisopropyl-1,2-propylènediamine,
N,N,N',N'-tétrabutyl-1,2-propylènediamine,
N,N,N',N'-tétraisobutyl-1,2-propylènediamine,
N,N,N',N'-tétraméthyl-1,3-propylènediamine,
N,N,N',N'-tétraéthyl-1,3-propylènediamine,
N,N,N',N'-tétrapropyl-1,3-propylènediamine,
N,N,N',N'-tétraisopropyl-1,3-propylènediamine,
N,N,N',N'-tétrabutyl-1,3-propylènediamine,
N,N,N',N'-tétraisobutyl-1,3-propylènediamine,
N,N,N',N'-tétraméthyl-1,2-butylènediamine,
N,N,N',N'-tétraéthyl-1,2-butylènediamine,
N,N,N',N'-tétrapropyl-1,2-butylènediamine,
N,N,N',N'-tétraisopropyl-1,2-butylènediamine,
N,N,N',N'-tétrabutyl-1,2-butylènediamine,
N,N,N',N'-tétraisobutyl-1,2-butylènediamine,
N,N,N',N'-tétraméthyl-1,3-butylènediamine,
N,N,N',N'-tétraéthyl-1,3-butylènediamine,
N,N,N',N'-tétrapropyl-1,3-butylènediamine,
N,N,N',N'-tétraisopropyl-1,3-butylènediamine,
N,N,N',N'-tétrabutyl-1,3-butylènediamine,
N,N,N',N'-tétraisobutyl-1,3-butylènediamine,
N,N,N',N'-tétrabutyl-1,4-butylènediamine,
N,N,N',N'-tétraméthyl-1,4-butylènediamine,
N,N,N',N'-tétraéthyl-1,4-butylènediamine,
N,N,N',N'-tétrapropyl-1,4-butylènediamine,
N,N,N',N'-tétraisopropyl-1,4-butylènediamine,
N,N,N',N'-tétrabutyl-1,4-butylènediamine,
N,N,N',N'-tétraisobutyl-1,4-butylènediamine,
N,N,N',N'-tétraméthyl-1,5-pentylènediamine,
N,N,N',N'-tétraéthyl-1,5-pentylènediamine,
N,N,N',N'-tétraméthyl-1,6-hexylènediamine, et
N,N,N',N'-tétraéthyl-1,6-hexylènediamine,
et
qui comprend en outre un tensioactif non ionique possédant un groupe alkylèneoxy,
ledit tensioactif non ionique étant représenté par la formule suivante (S1) ou (S2) : 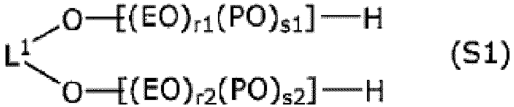
R^{a}O⁅(EO)ᵣ₃(PO)ₛ₃⁆H (S2)
dans lesquelles EO et PO représentent respectivement - (CH₂)₂-O- et -CH₂-CH(CH₃)-O-, étant entendu que les motifs de chacun parmi EO et PO peuvent se combiner les uns avec les autres, soit de manière aléatoire, soit pour former un bloc ; L¹ est une chaîne hydrocarbonée à 1 à 30 atomes de carbone qui peut contenir une liaison insaturée ; R^{a} est une chaîne hydrocarbonée saturée ou insaturée de 5 à 30 atomes de carbone ; chacun parmi r1 à r3 et s1 à s3 est un entier de 20 ou moins pour indiquer le degré de répétition de EO ou de PO ; chacun parmi r1 + s1 et r2 + s2 est indépendamment un entier de 0 à 20, étant entendu que r1 + s1 + r2 + s2 est un entier de 1 ou plus ; et r3 + s3 est un entier de 1 à 20, préférablement, de 2 à 10.

2. Solution de rinçage pour la lithographie selon la revendication 1, la teneur dudit composé contenant de l'azote n'étant pas inférieure à 0,005 % mais pas supérieure à 5 % sur la base du poids total de ladite solution de rinçage.

3. Solution de rinçage pour la lithographie selon la revendication 1 ou 2, la teneur dudit tensioactif non ionique étant de 0,01 à 10 % en poids sur la base du poids total de ladite solution de rinçage.

4. Solution de rinçage pour la lithographie selon l'une quelconque des revendications 1 à 3, qui comprend en outre un agent bactéricide, bactériostatique, conservateur, ou antifongique.

5. Solution de rinçage pour la lithographie selon la revendication 4, la teneur de l'agent bactéricide, bactériostatique, conservateur, ou antifongique étant comprise entre pas moins de 0,001 % en poids et pas plus de 1 % en poids sur la base du poids total de ladite solution de rinçage.

6. Solution de rinçage pour la lithographie selon l'une quelconque des revendications 1 à 5, qui comprend en outre un co-solvant miscible à l'eau ou soluble dans l'eau.

7. Solution de rinçage pour la lithographie selon la revendication 6, la teneur du co-solvant étant comprise entre pas moins de 0,1 % en poids et pas plus de 15 % en poids sur la base du poids total de ladite solution de rinçage.

8. Procédé de formation de motifs comprenant les étapes de :
(1) revêtement d'un substrat avec une composition de résine photosensible pour former une couche de composition de résine photosensible ;
(2) soumission de ladite couche de composition de résine photosensible à une exposition,
(3) développement de la couche de composition de résine photosensible avec une solution de développement, et
(4) traitement du substrat avec la solution de rinçage pour la lithographie selon l'une quelconque des revendications 1 à 7.
